# EUROPÄISCHE PATENTSCHRIFT

(11) **EP 1 474 090 B1**
(45) Veröffentlichungstag und Bekanntmachung des Hinweises auf die Patenterteilung: **11.04.2012**
(21) Anmeldenummer: 03708003.3
(22) Anmeldetag: 23.01.2003
(51) Int. Cl.: A61J 7/04, A61J 1/03

(54) **EINRICHTUNG ZUR ERFASSUNG DER PRODUKTENTNAHME DURCH EINE ELEKTRONISCHE VORRICHTUNG AUS EINER VERPACKUNGSANORDNUNG**
DEVICE FOR DETECTING THE REMOVAL OF A PRODUCT FROM A PACKING SYSTEM BY AN ELECTRONIC UNIT
SYSTEME POUR DETECTER AU MOYEN D'UN DISPOSITIF ELECTRONIQUE LE RETRAIT DE PRODUITS D'UN EMBALLAGE

(30) Priorität: 14.02.2002 DE 10206138; 26.03.2002 DE 10213594
(43) Veröffentlichungstag der Anmeldung: 10.11.2004
(73) Patentinhaber: Simon, Udo, 90409 Nürnberg (DE); Radtke, Ernst-Rudolf, 91207 Lauf a. d. Peg. (DE)
(72) Erfinder: Simon, Udo, 90409 Nürnberg (DE); Radtke, Ernst-Rudolf, 91207 Lauf a. d. Peg. (DE)
(74) Vertreter: von Puttkamer, Nikolaus
(86) Internationale Anmeldenummer: PCT/DE2003/000180
(87) Internationale Veröffentlichungsnummer: WO 2003/068138

(56) Entgegenhaltungen:
- WO-A-96/04881
- US-A- 4 125 190
- US-A- 4 526 474
- US-A- 4 660 991
- US-A- 6 006 913

## Beschreibung

Die vorliegende Erfindung betrifft eine Einrichtung zur Erfassung der Produktentnahme durch eine elektronische Vorrichtung aus einer Verpackungsanordnung.

Es sind Blisterpackungsanordnungen bekannt, bei denen auf der Oberfläche der Siegelfolie Leiterbahnen angeordnet sind, die über die Bereiche der Taschen der Blisterpackungsanordnung verlaufen und bei der Entnahme eines Medikamentes aus einer Tasche unterbrochen werden. Die Blisterpackungsanordnung ist mit einer Elektronikeinheit verbindbar, die solche Unterbrechungen zur Erfassung der Medikamentenentnahme ermittelt und speichert.

Ein Problem besteht dabei darin, dass die Blisterpackungen bei ihrer Herstellung mit den Leiterbahnen bedruckt werden müssen, was aufwendige und kostspielige Verfahrensschritte und Produktionsanlagen erfordert. Aus diesem Grunde sind solche Blisterpackungsanordnungen insbesondere nicht für die Durchführung von Pilotprojekten geeignet, bei denen Blisterpackungen nur in relativ kleinen Stückzahlen hergestellt und verwendet werden.

Die vorliegende Erfindung geht von der gattungsgemäßen US 4 660 991 A aus. Bei der aus dieser Druckschrift bekannten Einrichtung zur Erfassung der Zeit der Entnahme einer Tablette aus einer Blisterpackung sind eine Deckschicht mit individuellen Leiterbahnen und eine Trägerplatte mit Durchgangsöffnungen bekannt. Die Trägerplatte ist dabei Teil einer die Blisterpackung und die auf die Trägerplatte aufgelegte Deckschicht haltenden Halteeinrichtung. Wenn die Deckschicht und die darauf angeordnete Blisterpackung in der Halteeinrichtung angeordnet sind, sind Bereiche der individuellen Leiterbahnen der Deckschicht und die Durchgangsöffnungen der Trägerplatte den Taschen der Blisterpackung jeweils zugeordnet, sodass bei der Entnahme einer Tablette aus einer Tasche der dieser tasche zugeordnete Bereich einer individuellen Leiterbahn durchtrennt wird.

Die Aufgabe der vorliegenden Erfindung besteht darin, eine Einrichtung zu schaffen, mit der die Produktentnahme aus einer Verpackungsanordnung in einer äußerst einfachen, und sicheren Weise erfasst werden kann.

Diese Aufgabe wird durch eine Einrichtung mit den Merkmalen des Patentanspruches 1 gelöst.

Ein besonderer Vorteil der vorliegenden Erfindung besteht darin, dass die vorliegende Einrichtung als Schichtenverbund ausgebildet ist, der aus einer die Leiterbahnen tragenden Deckschicht und einer Trägerplatte besteht, in der Öffnungen zum Durchführen von Produkten aus einer mit dem Schichtenverbund verbundenen Verpackungsanordnung vorgesehen sind. Dieser Schichtenverbund ist bedarfsweise mit zu ihm passenden Verpackungsanordnungen verbindbar.

Die Kontaktflecken der durchtrennbaren, leiterbahnführenden Deckschicht und die Kontaktflecken der Trägerplatte sind bei der erfindungsgemäßen Einrichtung zweckmaßigerweise mittels eines leitfähigen Klebers dauerhaft verbunden- Vorteilhaft ist dabei, dass durch diese dauerhafte Verbindung eine sichere Kontaktierung zwischen den Kontaktflecken der Deckschicht und der Trägerplatte gewährleistet ist.

Ein besonderer Vorteil einer Ausgestaltung der vorliegenden Erfindung besteht darin, dass die vorliegende Einrichtung so ausgestaltet sein kann, dass eine Produktentnahme durch Kleinkinder sicher vermieden wird. Zu diesem Zweck weist die Trägerplatte an ihrer der Verpackungsanordnung abgewandten Seite eine Abdeckschicht auf. Vor der Entnahme eines Produkts aus der mit der Einrichtung verbundenen Verpackungsanordnung muss ein Abziehbereich aus der Abdeckschicht herausgetrennt und abgezogen werden, der die entsprechende Öffnung der Trägerplatte abdeckt. Erst nach dem Abziehen eines Abziehbereiches kann das entsprechende Produkt durch die entsprechende Öffnung der Trägerplatte ausgedrückt werden. Die der Tasche der Verpackungsanordnung zugeordnete Leiterbahn der Abdeckschicht wird dabei irreversibel durchtrennt und eine Elektronikeinheit erkennt die Zustandsveränderung der mit der Einrichtung verbundenen Verpackungsanordnung. Dabei befindet sich die Elektronikeinheit in einer Haltevorrichtung, in die die mit der vorliegenden Einrichtung verbundene Verpackungsanordnung eingeschoben wird.

Ein weiterer, wesentlicher Vorteil eienr weiteren Ausgestaltung der vorliegenden Erfindung besteht darin, dass beim Einstecken der mit der Verpackungsanordnung verbundenen Einrichtung in die Haltevorrichtung sichergestellt ist, dass die Trägerplatte automatisch in die richtige Steckverbindungslage gerät, so dass die Leiterbahnen mit der Elektronikeinheit richtig verbunden werden.

Eine asymmetrische Anordnung von Führungselementen, vorzugsweise Stanzungen, lassen bei einer bevorzugten Weiterbildung der Erfindung nur eine eindeutige Positionierung der mit der Verpackungsanordnung verbundenen Einrichtung in der Haltervorrichtung zu.

Fehlerhafte Signalerfassungen durch fehlerhaftes Einstecken der mit der Verpackungsanordnung verbundenen Einrichtung in die Haltevorrichtung können vorteilhafterweise sicher vermieden werden. Dies wird bei einer Weiterbildung der Erfindung dadurch erreicht, dass die Elektronikeinheit erst dann aktiviert wird, wenn sich die Einrichtung in der richtigen Steckkontaktlage befindet. Dadurch können Probleme vermieden werden, die auf Vorgänge beim Einstecken der Einrichtung in die Haltevorrichtung zurückzuführen sind. Solche Vorgänge könnten nach der Herstellung einer individuellen elektrischen Verbindung zwischen der Einrichtung und der Elektronikeinheit bei Relativbewegungen zwischen der Einrichtung und der Haltevorrichtung beim Einstecken zu Kontaktunterbrechungen führen, die eine Produktentnahme simulieren könnten.

Bei einer vorteilhaften Weiterbildung der Erfindung ermöglicht eine Kodierung der Trägerplatte durch Stanzungen, Lochungen, Schlitzungen, Barcode oder elektronische Verfahren etc. eine Erkennung durch die Elektronikeinheit, welches Produkt in der mit der Einrichtung verbundenen Verpackungsanordnung untergebracht ist. Diese Kodierung ist z.B. durch die Einstanzung von Schlitzen in die Trägerplatte möglich, die geschlossene Kontakte der Elektronikeinheit unterbricht, oder durch das Aufdrucken von leitfähigen Kontaktflecken auf die Trägerplatte realisierbar, deren unterschiedliche Anordnung einem entsprechenden, in der Verpackungsanordnung enthaltenen Produkt zugeordnet werden kann.

Um den Verbund zwischen der Einrichtung und der Verpackungsanordnung dauerhaft herzustellen, werden bei einer Weiterbildung der Erfindung vorzugsweise die Randbereiche der Verpackungsanordnung und/oder der Einrichtung umlaufend mit einem Kleber verbunden. Somit ist eine weitgehend dauerhafte Verbindung zwischen der Verpackungsanordnung und der leiterbahnführenden, durchtrennbaren Deckschicht und der Trägerplatte der vorliegenden Einrichtung sichergestellt.

Vorteilhafterweise sind bei einer weiteren Ausgestaltung der erfindungsgemäßen Einrichtung eine wirtschaftlich sinnvolle Herstellung und das lageorientierte Zusammenführen von Verpackungsanordnung und Einrichtung gewährleistet-Dies wird dadurch gelöst, dass auf der Deckfolie der Verpackungsanordnung eine oder mehrere Passermarken aufgedruckt werden, die z.B. von einem optischen Steuergerät oder durch ein oder mehrere Fenster der Einrichtung gelesen werden können. Diese Art der Herstellung erfolgt in der Industrie üblicherweise unter dem Begriff "Herstellung von Rolle zu Rolle". Das heißt, dass auf den mit Produkten befüllten und mit einer Siegelfolie gesiegelten Verpackungsanordnungen die erfindungsgemäße Einrichtungen von einer Rolle kommend einer Maschine zugeführt werden, die die Einrichtungen lageorientiert, d.h. passergenau auf den Verpackungsanordnungen aufbringt und die Verpackungsanordnungen und die Einrichtungen jeweils durch einen - vorzugsweise - Klebe/Siegelvorgang dauerhaft verbindet. Ein anschließender Stanzvorgang stanzt die endgültige, gewünschte Form der Verpackungsanordnungen.

Es ist gemäß einer Ausgestaltung der Erfindung aber auch möglich, eine bereits ausgestanzte verpackungsanordnung mit einer Einrichtung passergenau dauerhaft zu verbinden. Hierzu legt man die Verpackungsanordnung in eine Aufnehmung, die die Taschen und/oder eine Sicke der Verpackungsanordnung aufnimmt. Auf die plan liegende Unterseite der Verpackungsanordnung, also auf die Siegelfolie der Verpackungsanordnung, wird die Einrichtung aufgebracht. Die Lageorientierung erfolgt hierbei ebenfalls durch die Passermarken, die elektronisch gelesen bzw. gesteuert werden und/oder durch mechanische Führungshilfen.

Im folgenden werden die Erfindungen, deren Ausgestaltungen im Zusammenhang mit den Figuren näher erläutert. Es zeigen:
Figur 1, die Trägerplatte der vorliegenden Einrichtung von oben her gesehen mit den Öffnungen, die deckungsgleich zu den Taschen der anzubringenden Verpackungsanordnung ausgerichtet sind, sowie den gemeinsamen AnschlussKontaktflecken und die individuellen Anschlusskontaktflecken;
Figur 2 die Deckschicht mit den Leiterbahnen der vorliegenden Einrichtung von unten her gesehen;
Figur 3 die Trägerplatte von unten gesehen mit teilweiser Aufsicht auf die Deckschicht und deren individuelle Leiterbahnen durch die Öffnungen der Trägerplatte;
Figur 4 einen Schnitt durch die Verpackungsanordnung und die verschiedenen Schichten der erfindungsgemäßen Einrichtung, wobei unterhalb der Verpackungsanordnung die Deckschicht mit den Leiterbahnen dargestellt ist, die mittels eines leitfähigen Klebstoffes mit der Trägerplatte verbunden wird, wobei zur Kleinkindersicherheit auf der Unterseite der Trägerplatte eine Abdeckschicht aufgebracht sein kann, deren abtrennbare Abziehbereiche die Öffnungen der Trägerplatte verdecken;
Figur 4a die einzelnen Schichten des Schichtenverbundes der erfindungsgemäßen Einrichtung im miteinander verbundenen Zustand;
Figur 4b die einzelnen Schichten des Schichteverbundes der erfindungsgemäßen Einrichtung und die mit dieser verbundene Verpackungsanordnung;
Figur 5 die mit der Abdeckschicht versehene Trägerplatte, wobei die abziehbaren Abziehbereiche sichtbar sind;
Figur 6 eine Darstellung zur Erläuterung der Funktionsweise der vorliegenden Einrichtung, wobei ein Produkt aus einer Verpackungsanordnung ausgedrückt wurde, nachdem vorher ein Abziehbereich der Abdeckschicht entfernt wurde, der zur Kleinkindersicherheit dient;
Figur 7a die mit der vorliegenden Einrichtung verbundene Verpackungsanordnung vor dem Einschieben in die Haltevorrichtung.
Figur 7b die mit der vorliegenden Einrichtung verbundene Verpackungsanordnung nach dem Einschieben in die Haltevorrichtung;
Figuren 8 - 12 Weiterbildungen der Erfindung.

Zu der Erfindung führten die folgenden Überlegungen. Um insbesondere in der Pilotphase bei der Entwicklung und der Erprobung von Verpackungsanordnungen, bei denen eine elektronische Überwachung der Produktentnahme erfolgt, insbesondere von Blisterpackungen, hohe Kosten bei der Herstellung zu vermeiden, die auf das Bedrucken der Verpackungsanordnungen mit Leiterbahnen zurückzuführen sind, wird vorgeschlagen, eine aus mehreren Schichten bestehende Einrichtung getrennt von den Verpackungsanordnungen herzustellen und nachfolgend mit diesen zu verbinden. Auf diese Weise werden auf der Seite der Herstellung von Verpackungsanordnungen entstehende Kosten vermindert und können die getrennt hergestellten Einrichtungen zur sicheren Erfassung der Produktentnahme, getrennt hergestellt und bedarfsweise mit Verpackungsanordnungen verbunden werden. Dabei sind die Einrichtungen individuell auf die Verpackungsanordnungen abgestellt.

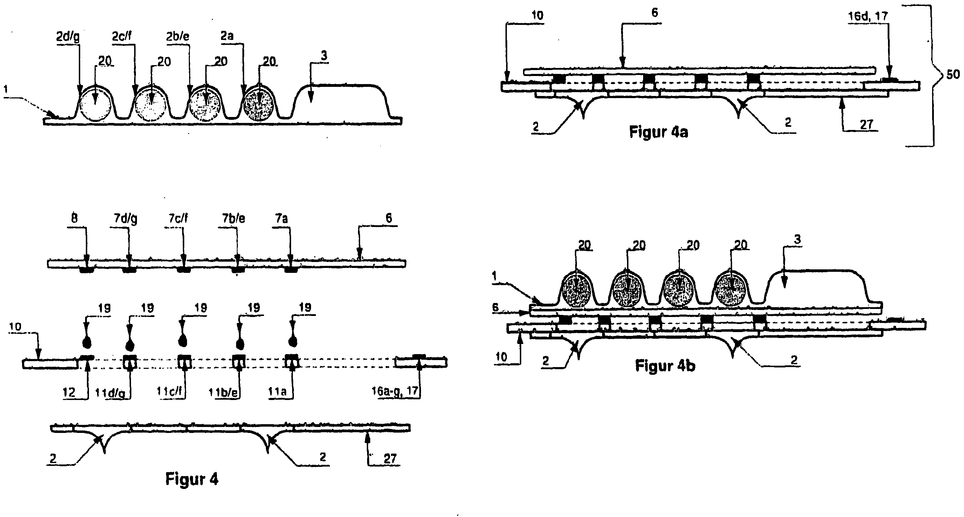

Die vorliegende Einrichtung besteht im wesentlicher, aus einem aus der Figur 4a ersichtlichen Schichtenverbund 50, der mit einer Verpackungsanordnung 1 gemäß Figur 4b verbunden wird.

Die Verpackungsanordnung 1 weist dabei in an sich üblicher Weise mehrere Taschen 2a bis 2g zur Aufnahme von z.B. Medikamenten, insbesondere Tabletten, elektronischen Bauteilen, Süßigkeiten oder sonstigen Produkten 20 auf.

Beispielsweise weist die Verpackungsanordnung 1 in Längsrichtung verlaufend zwei nebeneinander angeordnete Taschenreihen mit jeweils drei Taschen 2b, 2c, 2d bzw. 2e, 2f, 2g und eine an den einen Enden der sich gegenüberliegenden Reihen mittig angeordnete weitere Tasche 2a auf. An der den beiden Taschenreihen abgewandten Seite der mittleren Tasche 2a kann ein größeres taschenförmiges Abteil 3 angeordnet sein, in dem ein gefalteter Informationszettel oder dergleichen angeordnet sein kann. Andere Taschenanordnungen bzw. -muster sind möglich.

Der Schichtverbund 50 besteht aus einer Trägerschicht bzw. Trägerplatte 10, die vorzugsweise aus einem insbesondere flexiblen Kunststoffmaterial, vorzugsweise PVC, besteht und einer mit individuellen Leiterbahnen 7a' bis 7g' versehenen Deckschicht 6, die an einer Seite der Trägerplatte 10 so angeordnet ist, dass die individuellen Leiterbahnen 7a' bis 7g' an der der Trägerplatte 10 angewandten und der zu befestigenden Verpackungsanordnung 1 zugewandten Seite angeordnet sind. Gegebenenfalls ist eine Abdeckschicht 27, die später näher erläutert wird, an der der Deckschicht 6 gegenüberliegenden Seite der Trägerplatte 10 angeordnet.

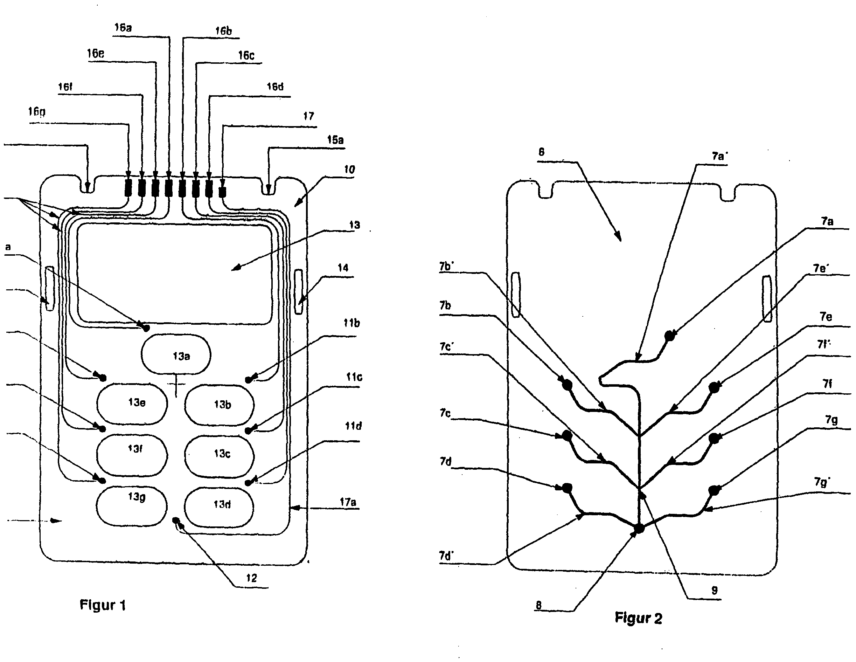

Auf der Deckschicht E sind gemäß Figur 2 verschiedene individuelle Kontaktflecken 7a bis 7g angeordnet, von denen jeweils ein Kontaktfleck einer Durchstanzung bzw. Öffnung 13a und 13g der Trägerplatte 10 zugeordnet und in deren Nähe angeordnet ist.

Von jedem individuellen Kontaktfleck 7a bis 7g aus verläuft eine individuelle Leiterbahn 7a' bis 7g' der Deckschicht 6 über eine entsprechende Öffnung 13a bis 13g der darunter befindlichen Trägerplatte 10 zu einer vorzugsweise zwischen den beiden Reihen der Öffnungen der Trägerplatte 10 zentral verlaufenden gemeinsamen Leiterbahn 9 der Deckschicht 6, die mit einem gemeinsamen Kontaktfleck 8 der Deckschicht 6 verbunden ist.

Durch diese Anordnung ist sichergestellt, dass von dem gemeinsamen Kontaktfleck 8 der Deckschicht 6 aus eine elektrische Verbindung über jeweils eine über eine Öffnung 13a bis 13g verlaufende Leiterbahn 7a' bis 7g' zu dem der jeweiligen Öffnung 13a bis 13g zugeordneten individuellen Kontaktfleck 7a bis 7g besteht.

Die Verpackungsanordnung 1 wird so auf den Scichtenverbund 50 aufgebracht, dass die Ausdrückbereiche der Taschen 2a bis 2g zu den Öffnungen 13a bis 13g der Trägerplatte 10 ausgerichtet sind. Im Falle einer Produktentnahme aus einer Tasche 2a bis 2g wird die der Tasche bzw. Öffnung zugeordnete elektrische Verbindung zwischen dem gemeinsamen Kontaktfleck E und dem jeweiligen individuellen Kontaktfleck 7a bis 7a unterbrochen.

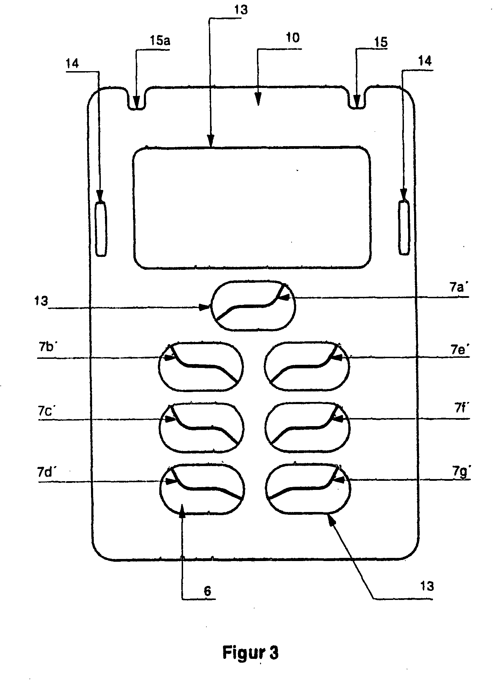

Der so ausgestalteten Deckschicht 6 ist die bereits erwähnte Trägerplatte 10 zugeordnet, die aus den Figuren 1 und 3 ersichtlich ist. Entsprechend dem Muster der Kontaktflecken 7a bis 7g und 8 der Deckschicht 6 weist die Trägerplatte 10 an ihrer einen Seite ein Muster von individuellen Kontaktflecken 11a bis 11g und einem gemeinsamen Kontaktfleck 12 auf, wobei die Kontaktflecken 11a und 11g deckungsgleich zu den individuellen Kontaktflecken 7a bis 7g der Deckschicht 6 und der gemeinsame Kontaktfleck 12 deckungsgleich zu dem gemeinsamen Kontaktfleck 8 der Deckschicht 6 ausrichtbar sind, wenn die Unterseite der Deckschicht 6 auf die die Kontaktflecken 11a bis 11g und 12 aufweisende Fläche der Trägerplatte 10 aufgelegt wird.

Entsprechend dem Muster der Taschen 2a bis 2g und des Abteils 3 der Verpackungsanordnung 1 weist die Trägerplatte 10 den Taschen 2a bis 2 g entsprechende Öffnungen 13a bis 13g und eine dem Abteil 3 entsprechende Öffnung 13 auf, die zu den Taschen 2a bis 2g bzw. dem Abteil 3 ausrichtbar sind.

Der Schichtverbund 50 ist vorzugsweise so bemessen, dass die Trägerplatte 10 nach der später erläuterten Verbindung mit der Verpackungsanordnung 1 an allen Seiten über die Verpackungsanordnung 1 übersteht.

Die Figuren 4, 4a und 4b zeigen im Schnitt gesehen, wie die Deckschicht 6 an der Trägerplatte 10 befestigt wird, wobei dann die individuellen Kontaktflecken 7a bis 7g der Deckschicht 6 (vgl. Figur 2) mit den entsprechenden individuellen Kontaktflecken 11a bis 11g (vgl. Figur 4, 4a) der Trägerplatte 10 und der gemeinsame Kontaktfleck 8 der verpackungsanordnung 1 mit dem gemeinsamen Kontaktfleck 12 der Trägerplatte 10 elektrisch verbunden werden. Die Figur 4b zeigt im Schnitt gesehen den Zustand, in dem die Verpackungsanordnung 1 mit dem Schichtverbund 50 der vorleigender Einrichtung verbunden ist. Hierbei ist es von großer Wichtigkeit, dass das Abteil 3 und die Taschen 2a bis 2c der Verpackungsanordnung 1 zu den Öffnungen 13, 13a bis 13g der Trägerplatte 10 ausgerichtet sind.

Gemäß Figur 4 wird dies dadurch erreicht, dass die Trägerplatte 10 und die Deckschicht 6 nach Anordnung von Leitkleberpunkten 19 auf den Kontaktflecken 11a bis 11g und 12 der Trägerplatte 10 des Schichtenverbundes 50 und/oder auf den Kontaktflecken 7a bis 7g und 8 der Deckschicht 6 zueinander ausgerichtet und aufeinander gepresst werden. Dabei entstehen nach dem Aushärten der Leitkleberpunkte 19 elektrische Verbindungen zwischen den einander zugeordneten Kontaktflecken 7a bis 7g und 8 der Deckschicht 6 und den Kontaktflecken 11a bis 11g und 12 der Trägerplatte 10.

Wie die Figur 1 zeigt, befinden sich an einer Seite, vorzugsweise einer Stirnseite der Trägerplatte 10 individuelle Anschlusskontaktflecken 16a bis 16g und ein gemeinsamer Anschlusskontaktfleck 17 vorzugsweise nebeneinander in einer Reihe. Jeder individuelle Anschlusskontaktfleck 16a bis 16g ist über eine individuelle Leiterbahn 16 mit einem bestimmten Kontaktfleck 11a bis 11g der Trägerplatte 10 verbunden. Der gemeinsame Anschlusskontaktfleck 17 ist über eine gemeinsame Leiterbahn 17a mit dem gemeinsamen Kontaktfleck 12 der Trägerplatte 10 verbunden.

Somit bestehen bei dem fertig hergestellten Schichtenverbund 50 der vorliegenden Einrichtung gemäß den Figuren 4a und 4b elektrische Verbindungen zwischen jedem individuellen Anschlusskontaktfleck 16a bis 16g, über individuelle Leiterbahnen 16 (vgl. Figur 1), zu den individuellen Kontaktflecken 11a bis 11g der Trägerplatte 10 und über die Leitkleberpunkte 19, zu den individuellen Kontaktflecken 7a bis 7g der Abdeckschicht 6. Dies gilt auch für die gemeinsamen Kontaktflecken 17, 12, 8.

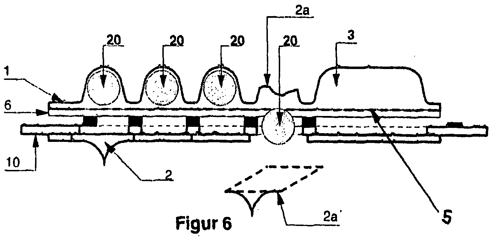

Bei der Entnahme eines Produkes 20 aus der Verpackungsanordnung 1, beispielsweise bei der Entnahme des Produkts 20 aus der Tasche 2a der Figur 6, werden durch das Ausdrücken des Produkts 20 aus der Verpackungsanordnung 1 sowohl die Siegelfolie 5 der Verpackungsanordnung 1 als auch die individuelle Leiterbahn 7a der Deckschicht 6 durchbrochen, sodass die entsprechende elektrische Verbindung zur Anzeige der speziellen Produktentnahme unterbrochen wird. Alle anderen elektrischen Verbindungen bleiben dabei bestehen.

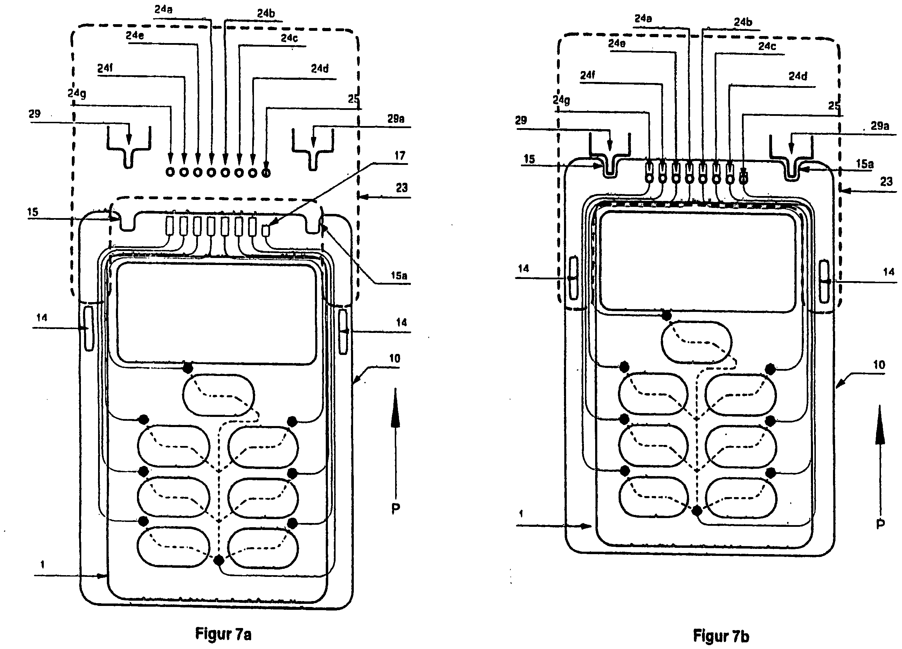

Der vorliegende Schichtenverbund 50 wird gemäss den Figuren 7a, 7b in ein schematisch dargestelltes Aufnahmeteil 23 einer nicht näher dargestellten Haltevorrichtung eingeschoben, wobei die im Aufnahmeteil 23 enthaltene Elektrcnikeinheit bzw. ein Elektronikmodul (nicht dargestellt) über die individuellen Anschlusskontaktflecken 24a bis 24g und dem gemeinsamen Anschlusskontaktfleck 25 mit den Anschlusskontaktflecken 16a bis 16g und 17 (vgl. Figur 4) des Schichtenverbundes 50 verbunden wird.

Um zu vermindern, dass beim Einschieben ein Stromfluss zwischen dem gemeinsamen Anschlusskontaktfleck 25 des Aufnahmeteiles 23 und einem individuellen Anschlusskontaktfleck 24a bis 24g des Aufnahmeteiles 23 zunächst hergestellt und beim weiteren Einschieben der Verpackungsanordnung 50 in das Aufnahmeteil 23 wieder unterbrochen wird, was von der Elektronikeinheit fälschlicherweise als Produktentnahme gedeutet würde, ist in der Einschubrichtung P der gemeinsame Anschlusskontaktfleck 17 der Trägerplatte 10 (vgl. Figur 7) kürzer bemessen als die individuellen Anschlusskontaktflecken 16a bis 16g der Trägerplatte 10, sodass ein Kontakt zwischen dem gemeinsamen Anschlusskontakflech 17 der Trägerplatte 10 und dem ihm zugeordneten gemeinsamen Kontaktfleck 25 des Aufnahmeteiles 23 erst dann hergestellt wird, wenn bereits zwischen den individuellen Anschlusskontaktflecken 16a bis 16g der Trägerplatte 10 und den zugeordneten individuellen Anschlusskontaktflecken 24a bis 24g des Aufnahmeteiles 23 sicher Kontakte hergestellt wurden.

Um eine Justierung und Ausrichtung der mit der Verpackungsanordnung 1 verbundenen vorliegenden Einrichtung quer zur Einschubrichtung P in Bezug auf das Aufnahmeteil 23 sicherzustellen, weist die Trägerplatte 10 stirnseitig an der Seite ihrer Anschlusskontaktfleckreihe 16a bis 15g, 17 eine Ausrichtnut 15 bzw. 15a auf, wobei diese Ausrichtnuten 15 und 15a unsymmetrisch zur Längsmittellinie der Trägerplatte 10 angeordnet sind (vgl. z.B. Figuren 7a, 7b). Im Aufnahmeteil 23 sind entsprechende Nasenteile 29 bzw. 29a (schematisch in Figuren 7a, 7b dargestellt) angeordnet, die in die Ausrichtnuten 15 bzw. 15a eingreifen, wenn die Trägerplatte 10 richtig im Aufnahmeteil 23 angeordnet ist. Nur dann können die elektrischen Verbindungen zwischen den Anschlusskontaktflecken 16a bis 16g sowie 17 und 24a bis 24g sowie 25 hergestellt werden.

Es wird darauf hingewiesen, dass in umgekehrter Weise die Nasenteile an der Verpackungsanordnung 1 und die Ausrichtnuten an dem Aufnahmeteil 23 angeordnet sein können.

Ebenso ist es auch denkbar, den Anschlusskontaktfleck 17 entsprechend den individuellen Anschlusskontaktflecken 16a bis 16g auszugestalten und statt dessen den gemeinsamen Anschlusskontaktfleck 25 im Aufnahmeteil 23 in der Einschubrichtung P kürzer auszugestalten als die individuellen Kontaktflecken im Aufnahmeteil 21, sodass beim Einschieben der Trägerplatte 10 in das Aufnahmeteil 23 in der Einschubrichtung P der Kontakt zwischen dem gemeinsamen Anschlusskontaktfleck 25 des Aufnahmeteiles 23 und dem gemeinsamen Anschlusskontaktfleck 17 der Trägerplatte 10 später hergestellt wird als die Kontakte zwischen den individuellen Anschlusskontaktflecken 24a bis 24g des Aufnahmeteiles 23 und den individuellen Anschlusskontaktflecken 16a bis 16g der Trägerplatte 10.

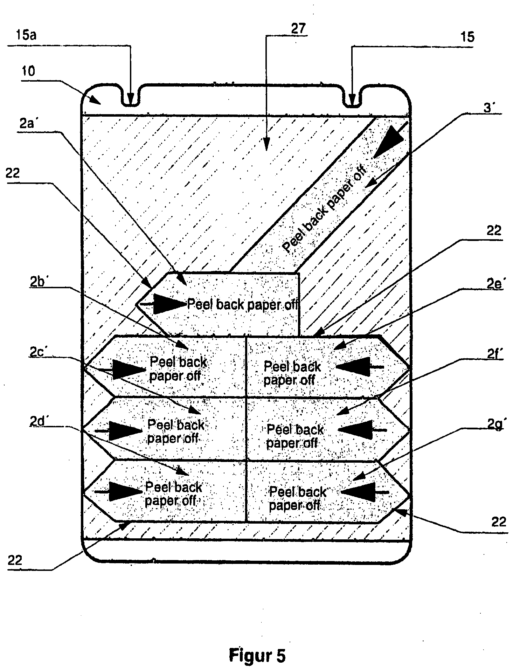

Im folgenden wird ein weiteres wesentliches Merkmal der vorliegenden Erfindung erläutert:
Auf der Unterseite der Trägerplatte 10 wird in der aus der Figur 5 ersichtlichen Weise eine weitere, vorzugsweise aus papierähnlichem Material bestehende Abdeckschicht 27 aufgebracht, die jeder individuellen Öffnung 13, 13a bis 13g bzw. der Trägerplatte 10 zugeordnet, einen Abziehbereich 3' bzw. 2a' bis 2g' aufweist, der den Randbereich der entsprechenden Öffnung überdeckt. Beim Gebrauch der Verpackungsanordnung 1 muss vor dem Ausdrücken eines Produkts 20 bzw. vor dem Öffnen des Abteils 3 der entsprechende Abziehbereich abgezogen werden.

Die Abziehbereiche 2a' bis 2g' und 3' sind durch eine durch Kraftaufbringung lösbare Klebeverbindung mit der Unterseite der Trägerplatte 10 und über Einstanzlinien 22 mit der Abdeckschicht 27 lösbar verbunden.

Hierdurch wird vermieden, dass Kleinkinder (in der Regel bis zum Alter von 42 Monaten) im Rahmen des ihnen eigenen Spieltriebes Produkte aus der Verpackungsordnung entnehmen, weil sie in der Regel nicht in der Lage sind, zwei verschiedene Operationen, nämlich das Abziehen eines Abziehbereiches und nachfolgend das Ausdrücken eines Produkts, auszuführen.

Gemäß Figur 1, ist es denkbar, in den Längsrändern der Trägerplatte 10 in der Einschubrichtung P verlaufende Schlitze 14 vorzusehen, die in entsprechende Vorsprünge (nicht dargestellt) des Aufnahmeteiles 23 bzw. der Haltevorrichtung eingreifen, wenn die Trägerplatte 10 im Aufnahmeteil 23 die richtige Lage erreicht. Auf diese Weise wird ein gegen unbeabsichtigtes Herausziehen gesicherter Halt der Verpackungsanordnung 1 im Aufnahmeteil 23 gewährleistet. Diese Schlitze 14 sind vor allem auch dann sinnvoll, wenn der Schichtenverbund 50 lageorientiert auf eine einzelne Verpackungsanordnung 1 aufgebracht werden soll.

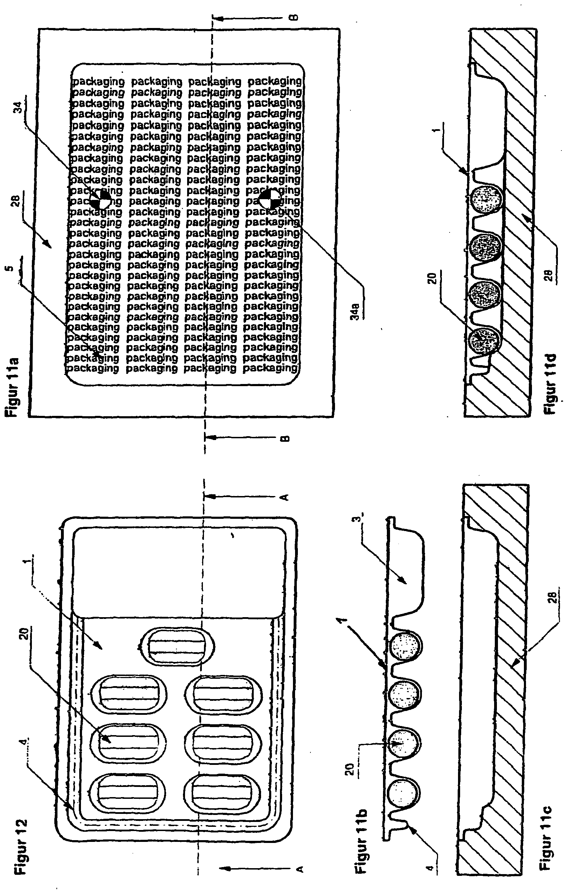

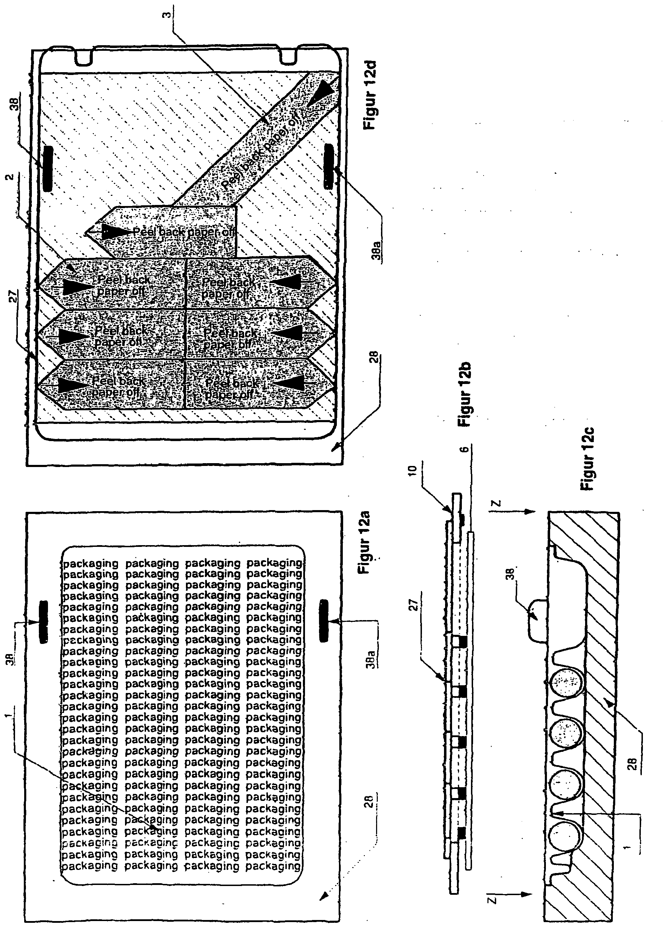

Figur 11c zeigt eine Aufnehmung 28, die eine Verpackungsanordnung 1 aufnimmt. Die innere Formgebung der Aufnehmung 28 entspricht der Form der Verpackungsanordnung 1. Gemäß Figur 11a (Draufsicht) und 11d (Schnitt) ist eine Verpackungsanordnung 1 in die Aufnehmung 28 eingelegt. Der Schichtenverbund 50, bestehend aus Deckschicht 6, Trägerplatte 10 und Abdeckschicht 27, kann nun mit der Verpackungsanordnung 1 in geeigneter Art und Weise verbunden werden. Zur exakten Positionierung der Öffnungen 13, 13a bis 13g wird die Verpackungsanordnung 1 mit den Schlitzen 14 der Trägerplatte 10 auf Führungshilfen 38, 38a der Aufnehmung 28 aufgelegt (vgl. Fig. 12a, 12c, 12d). Hierdurch justieren sich die Taschen 2a bis 2g der Verpackungsanordnung 1 zu den Öffnungen 13, 13a bis 13g der Trägerplatte 10 des Schichtenverbundes 50.

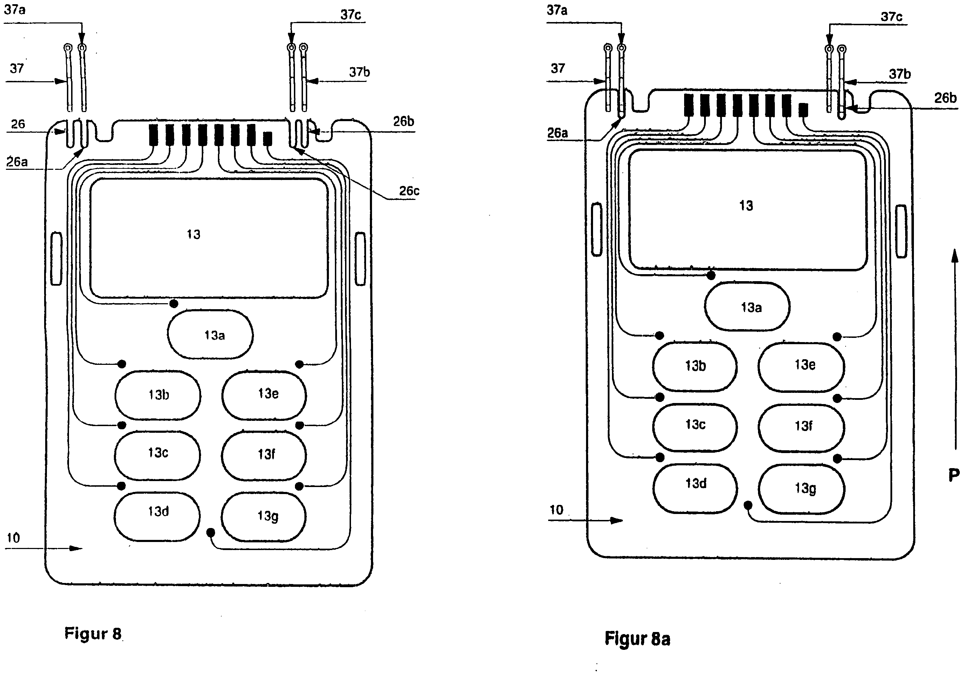

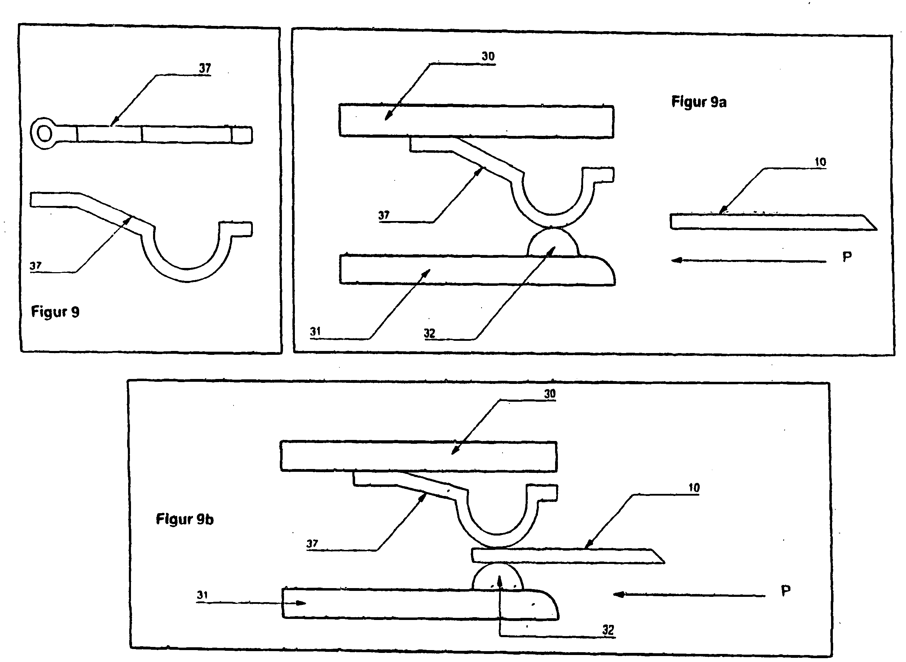

Um eine Anzeige des jeweiligen Verpackungsanordnungs-Inhaltes zu ermöglichen, kann die Trägerplatte 10 die bereits erwähnten Kodierungen aufweisen, die durch die Elektronikeinheit erfassbar sind. Eine bevorzugte Ausführungsform geht aus den Figuren 8, 8a, 9, 9a und 9b hervor.

In der Trägerplatte 10 des Schichtenverbundes 50 sind in der in das Aufnahmeteil 23 einzuschiebenden Stirnseite Kodierungsnuten 26, 26a bis 26c angeordnet, die mit Kontaktfedern 37, 37a bis 37c zusammen wirken, die in dem Aufnahmeteil 23 zweckmäßigerweise in der Einschubrichtung P angeordnet sind. Die Figur 9 zeigt eine solche Kontaktfeder 37 von oben und von der Seite gesehen. Im Aufnahmeteil 23 sind die Kontaktfedern 37 gemäß den Figuren 9a und 9b so an einer oberen Leiterplatte 30 befestigt, dass ihre Kontaktbereiche federnd an einem Kontaktfleck 32 einer unteren, der oberen Leiterplatte 30 gegenüberliegenden Leiterplatte 31 anliegen.

Je nachdem, ob die Kontaktfedern 37, 37a-c beim Einschieben der Trägerplatte 10 in der Einschubrichtung P auf eine Kodierungsnut 26, 26a bis 26c treffen oder nicht, wird der Kontakt zwischen Kontaktfeder und Kontaktfleck unterbrochen oder nicht. Auf diese Weise können bei z.B. vier Kontaktfedern je nach vorbestimmter Zuordnung von Kodierungsnuten oder keinen Kodierungsnuten verschiedene Aussagen über den Inhalt bzw. die Art der Verpackungsanordnung 1 getroffen und von der Elektronikeinheit erfasst bzw. angezeigt werden.

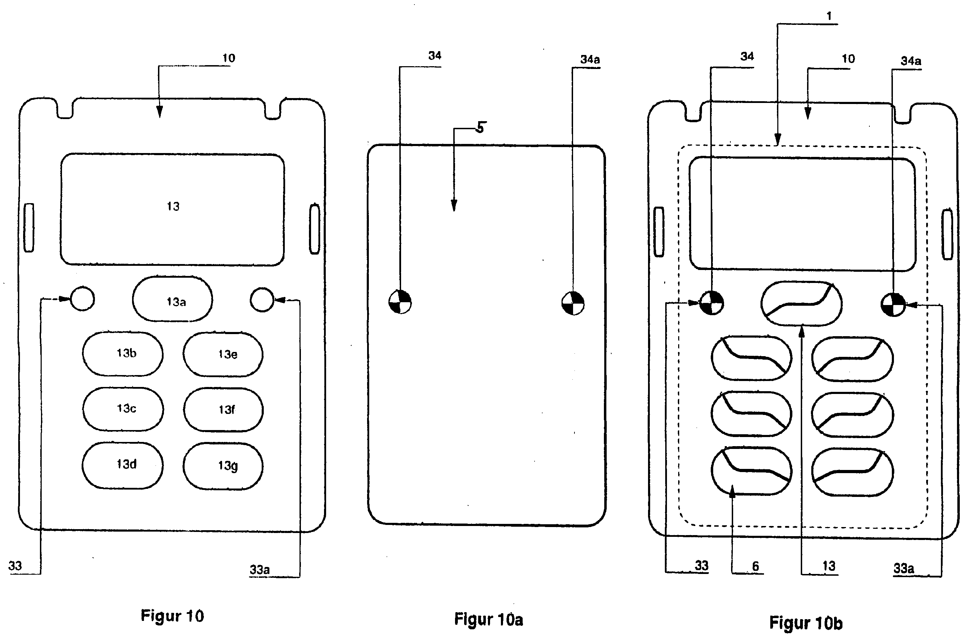

Im Zusammenhang mit den Figuren 10, 10a und 10b wird nun ein bevorzugtes Verfahren zum Aufbringen der vorliegenden Einrichtung auf der Siegelfolie 5 der Verpackungsanordnung 1 erläutert. Der Schichtenverbund 50 weist hierzu in seinen Schichten angeordnete Fenster 33, 33a auf, die in der richtigen Fixierungslage zu Passermarken 34, 34a ausgerichtet sind, die auf der Siegelfolie 5 der Verpackungsanordnung 1 aufgebracht sind. Nachdem z.B. die Randbereiche 1 der vierpackungsanordnungen 1 mit Leitkleberpunkten 19 versehen sind, werden die einzelnen bahnförmig hintereinander angeordneten Verpackungsanordnungen 1 in ihrer Längsrichtung verfahren, wobei von oben her ebenfalls bahnförmig hintereinander angeordnete Einrichtungen angenähert und schließlich parallel zu den Verpackungsanordnungen 1 verfahren werden, bis eine vorzugsweise optische Sensorik erkennt, dass die Fenster 33, 33a eines Schichtenverbundes 50 zu den Passermarken 34, 34a einer Verpackungsanordnung 1 ausgerichtet sind. Sobald dies der Fall ist, wird der Schichtenverbund 50 gegen die Verpackungsanordnung 1 gedrückt und mit der Siegelfolie 5 derselben verbunden, insbesondere verklebt.

## Patentansprüche

1. Einrichtung zur Erfassung der Produktentnahme aus einer Verpackungsanordnung (1) durch eine Elektronikeinheit, wobei die Produkte (20) in einzelnen, durch eine Siegelfolie (5) verschlossenen Taschen (2a bis 2g) angeordnet sind und wobei die Siegelfolie (5) zur Entnahme eines Produktes (20) aus einer Tasche (2a bis 2g) durchtrennbar ist, wobei die Einrichtung eine individuelle Leiterbahnen (7a' bis 7g`) tragende Deckschicht (6) und eine Trägerplatte (10) umfasst, wobei die Deckschicht (6) der Siegelfolie (5) der Verpackungsanordnung (1) derart zuordenbar ist, dass jeweils eine individuelle Leiterbahn (7a' bis 7b') der Deckschicht (6) ausgehend von einem individuellen Kontaktfleck (7a bis 7g) der Deckschicht (6) über einen jeweils einer Tasche (2a bis 2g) der Vepackungsanordnung (1) zuordenbaren Bereich der Deckschicht zu einer gemeinsamen Leiterbahn (9) der Deckschicht (6) verläuft, die mit einem gemeinsamen Kontaktfleck (8) der Deckschicht (6) verbunden ist, wobei die jeweilige über den der Tasche zu ordnenbaren Bereich der Dechschicht verlaufende individuelle Leiterbahn der Deckschicht bei der Entnahme eines Produktes (20) aus der entsprechenden Tasche (2a bis 2g) der Verpackungsanordnung (1) elektrisch unterbrechbar ist, wobei die Trägerplatte (10) Offnungen (13a bis 13g) aufweist, von denen jeweils eine einer Tasche (2a bis 2g) der Verpackungsanordnung (1) zuordenbar ist, wobei jeweils ein einer Tasche (2a bis 2g) der Verpackungsanordnung (1) entnommenes Produkt (20) durch die entsprechende Öffnung (13a bis 13g) der Trägerplatte (10) hindurchführbar ist, **dadurch gekennzeichnet, dass** die Deckschicht (6) und die Trägerplatte (10) als Schichtenverbund (50) ausgebildet sind, wobei die Dechschicht auf der Trägerplatte aufgebracht ist und der Schichten verbund mit der Verpackungsanordnung derart verbindbar ist, dass die Deckschicht der Siegelfolie der Verpackungsanordnung zugewandt ist, dass die Trägerplatte (10) an ihrer der Deckschicht (6) zugewandten Seite individuelle Kontaktflecken (11a bis 11g) der Trägerplatte (10) aufweist, die den individuellen Kontaktflecken (7a bis 7g) der Deckschicht (6) zugeordnet und im Schichtenverbund (50) mit diesen elektrisch verbunden sind, dass die Trägerplatte (10) einen gemeinsamen Kontaktfleck (12) aufweist, der dem gemeinsamen Kontaktfleck (8) der Deckschicht (6) zugeordnet und im Schichtenverbund mit diesem elektrisch verbunden ist, und dass jeder individuelle Kontaktfleck (11a bis 11g) der Trägerplatte (10) über eine individuelle Leiterbahn (16) der Trägerplatte (10) mit einem individuellen Anschlusskontaktfleck (16a bis 16g) der Trägerplatte (10) und der gemeinsame Kontaktfleck (12) der Trägerplatte (10) über eine gemeinsame Leiterbahn (17a) der Trägerplatte (10) mit einem gemeinsamen Anschlusskontaktfleck (17) der Trägerplatte (10) verbunden sind, wobei über die individuellen Anschlusskontaktflecken (16a bis 16g) der Trägerplatte (10) und den gemeinsamen Anschlusskontaktfleck (17) der Trägerplatte (10) eine elektrische Verbindung zu der Elektronikeinheit herstellbar ist, wenn der mit der Verpackungsanordnung (1) verbundene Schichtenverbund (50) in ein Aufnahmeteil (23) einer Haltevorrichtung eingeschoben wird, und dass die individuellen Kontaktflecken (7a bis 7g) der Deckschicht (6) und der gemeinsame Kontaktfleck (8) der Deckschicht (6) sowie die entsprechenden individuellen Kontakflecken (11a bis 11g) der Trägerplatte (10) bzw. der gemeinsame Kontaktfleck (12) der Trägerplatte (10) im Schichtenverbund jeweils über einen Leitkleberpunkt (19) miteinander elektrisch verbunden sind.

2. Einrichtung nach Anspruch 1, **dadurch gekennzeichnet, dass** die individuellen Leiterbahnen (7a' bis 7g'), die gemeinsame Leiterbahn (9), die individuellen Kontaktflecken (7a bis 7g) und der gemeinsame Kontaktfleck (8) der Deckschicht (6) auf der der Trägerplatte (10) zugewandten Seite angeordnet sind.

3. Einrichtung nach Anspruch 1 oder 2, **dadurch gekennzeichnet, dass** die individuellen Anschlusskontaktflecken (16a bis 16g) der Trägerplatte (10) und der gemeinsame Anschlusskontaktfleck (17) der Trägerplatte (10) an einer Stirnseite der Trägerplatte (10) angeordnet sind.

4. Einrichtung nach Anspruch 3, **dadurch gekennzeichnet, dass** in der Einschubrichtung gesehen der gemeinsame Anschlußkontaktfleck (17) der Trägerplatte (10) kürzer bemessen ist als die individuellen Anschlusskontaktflecken (16a bis 16g) der Trägerplatte (10) und dass die individuellen Anschlußkontaktflecken (16a bis 16g) der Trägerplatte (10) und der gemeinsame Anschlusskontaktfleck (17) der Trägerplatte (10) in einer Reihe angeordnet sind, so dass die Kontaktgabe in dem Aufnahmeteil (23) zum gemeinsamen Anschlusskontaktfleck (17) beim Einschieben der Trägerplatte (10) in das Aufnahmeteil (23) später erfolgt als zu den individuellen Anschlusskontaktflecken (16a bis 16g) der Trägerplatte (10).

5. Einrichtung nach einem der Ansprüche 1 bis 4, **dadurch gekennzeichnet, dass** die Trägerplatte (10) aus einem Kunststoffmaterial, vorzugsweise PVC, besteht.

6. Einrichtung nach einem der Ansprüche 1 bis 5, **dadurch gekennzeichnet, dass** die Trägerplatte (10) aus einem flexiblen Material besteht.

7. Einrichtung nach einem der Ansprüche 1 bis 6, **dadurch gekennzeichnet, dass** die Trägerplatte (10) entsprechend der Verpackungsanordnung (1) in Längsrichtung verlaufend zwei nebeneinander angeordnete Reihen von Öffnungen (13b, 13c, 13d; 13e, 13f, 13g) aufweist und eine an den einen Enden der sich gegenüberliegenden Reihen der öffnungen mittig angeordnete weitere Öffnung (13a) besitzt.

8. Einrichtung nach Anspruch 7, **dadurch gekennzeichnet, dass** die Trägerplatte (10) an der den beiden öffnungsreihen abgewandten Seite der weiteren Öffnung (13a) eine einem Abteil (3) der Verpackungsanordnung (1) zuordenbare Öffnung (13) aufweist.

9. Einrichtung nach einem der Ansprüche 1 bis 8, **dadurch gekennzeichnet, dass** der Schichtenverbund (50) an der der Deckschicht (6) abgewandten Seite der Trägerplatte (10) eine Abdeckschicht (27) mit Abziehbereichen (2a' bis 2g') aufweist, die die Öffnungen (13a bis 13g) der Trägerplatte (10) überdecken und zur Produktentnahme bedarfsweise aus der Abdeckschicht (27) herausziehbar sind.

10. Einrichtung nach Anspruch 9, **dadurch gekennzeichnet, dass** die Abdeckschicht (27) aus einem papierähnlichen Material besteht.

11. Einrichtung nach Anspruch 9 oder 10, **dadurch gekennzeichnet, dass** die Abziehbereiche (2a' bis 2g') durch eine durch Kraftaufbringung lösbare Klebeverbindung mit der ihnen zugewandten Seite der Trägerplatte (10) verbunden und über Einstanzlinien (22) mit der Abdeckschicht (27) lösbar verbunden sind.

12. Einrichtung nach einem der Ansprüche 1 bis 11, **dadurch gekennzeichnet, dass** der Schichtenverbund (50) an einer Stirnseite quer zur Einschubrichtung und unsymmetrisch zur Längsmittellinie des Schichtenverbundes (50) angeordnete Ausrichtnuten (15, 15a) oder Nasenteile aufweist, die in entsprechenden Nasenteile (29, 29a) oder Ausrichtnuten des Aufnahmeteils (23) eingreifen, wenn der Schichtenverbund (50) in das Aufnahmeteil (23) eingeschoben ist, wobei die individuellen Anschlusskontaktflecken (16a bis 16g) der Trägerplatte (10) und der gemeinsame Anschlußkontaktfleck (17) der Tragerplatte (10) an der Stirnseite so angeordnet sind, dass eine Kontaktgabe nur dann erfolgt, wenn die Nasenteile (29, 29a) in die Ausrichtnuten (15, 15a) eingreifen.

13. Einrichtung nach einem der Ansprüche 1 bis 12, **dadurch gekennzeichnet, dass** der Schichtenverbund (50) an seinem parallel zur Einschubrichtung verlaufenden Seitenränder Schlitze (14) aufweist, in die entsprechende Vorsprünge des Aufnahmeteiles (23) bzw. der Haltevorrichtung eingreifen, wenn der Schichtenverbund (50) im Aufnahmeteil (23) bzw. in der Haltevorrichtung die richtige Lage erreicht hat.

14. Einheit aus einer Verpackungsanordnung (1) und einer Einrichtung nach einem der Ansprüche 1 bis 13, **dadurch gekennzeichnet, dass** die Verbindung zwischen dem Schichtenverbund (50) und der Verpackungsanordnung (1) durch ein Klebemittel hergestellt ist.

15. Einheit nach Anspruch 14, **dadurch gekennzeichnet, dass** die Verpackungsanordnung (1) auf der Siegelfolie (5) Passermarken (34, 34a) aufweist, die durch entsprechende, im Schichtenverbund (50) angeordnete Fenster (33, 33a) sichtbar und detektierbar sind, wenn der Schichtenverbund (50) in Bezug auf die Verpackungsanordnung (1) die richtige Befestigungslage einnimmt.

## Claims

1. Device for decting the removal of a product from a packing system (1) by an electronic unit, wherein the products (20) are arranged in individual pockets (2a to 2g) sealed by a sealing film (5), and wherein the sealing film (5) can be perforated for the removal of a product (20) from a pocket (2a to 2g), wherein the device comprises a coating layer (6) carrying individual strip conductors (7a' to 7g') and a supporting plate (10), wherein the coating layer (6) can be assigned to the sealing film (5) of the packing system (1) in such a way that in each case an individual strip conductor (7a' to 7b') of the coating layer (6) runs from an individual contact pad (7a to 7g) of the coating layer (6) across an area of the coating layer (6) which can be assigned to a pocket (2a to 2g) of the packing system (1) to a common strip conductor (9) of the coating layer (6) connected to a common contact pad (8) of the coating layer (6), wherein the respective individual strip conductor (7a' to 7b') of the coating layer (6) running across the area of the coating layer (6) which can be assigned to the pocket (2a to 2g) is electrically interruptible by removing a product (20) from the respective pocket (2a to 2g) of the packing system (1), wherein the supporting plate (10) comprises openings (13a to 13g) each of which can be assigned to a pocket (2a to 2g) of the packing system (1), wherein in each case a product (20) removed from a pocket (2a to 2g) of the packing system (1) can be guided through the respective opening (13a to 13g) of the supporting plate (10), **characterized in that** the coating layer (6) and the supporting plate (10) are configured as a combination of layers (50), wherein the coating layer (6) is applied to the supporting plate (10) and the combination of layers (50) can be connected to the packing system (1) in such a way that the coating layer (6) faces the sealing film (5) of the packing system (1), **characterized in that** on the side facing the coating layer (6), the supporting plate (10) has individual contact pads (11a to 11g) of the supporting plate (10) which are assigned to the individual contact pads (7a to 7g) of the coating layer (6) and electrically connected thereto as a combination of layers (50), **characterized in that** the supporting plate (10) has a common contact pad (12) which is assigned to the common contact pad (8) of the coating layer (6) and electrically connected thereto as a combination of layers (50), and **characterized in that** each individual contact pad (11a to 11g) of the supporting plate (10) is connected to an individual contact pad (16a to 16g) of the supporting plate (10) via an individual strip conductor (16) of the supporting plate (10), and the common contact pad (12) of the supporting plate (10) is connected to a common contact pad (17) of the supporting plate (10) via a common strip conductor (17a) of the supporting plate (10), wherein an electrical connection to the electronic unit can be established via the individual contact pads (16a to 16g) of the supporting plate (10) and the common contact pad (17) of the supporting plate (10) when the combination of layers (50) connected to the packing system (1) is inserted into a receiving part (23) of a holding device, and **characterized in that** the individual contact pads (7a to 7g) of the coating layer (6) and the common contact pad (8) of the coating layer (6) as well as the corresponding individual contact pads (11a to 11g) of the supporting plate (10) and/or the common contact pad (12) of the supporting plate (10) are each electrically connected to each other as a combination of layers (50) by means of a conductive adhesive point (19).

2. Device according to claim 1, **characterized in that** the individual strip conductors (7a' to 7g'), the common strip conductor (9), the individual contact pads (7a to 7g) and the common contact pad (8) of the coating layer (6) are arranged on the side facing the supporting plate (10).

3. Device according to claim 1 or 2, **characterized in that** the individual contact pads (16a to 16g) of the supporting plate (10) and the common contact pad (17) of the supporting plate (10) are arranged on a front side of the supporting plate (10).

4. Device according to claim 3, **characterized in that**, when viewed in the insertion direction, the common contact pad (17) of the supporting plate (10) is dimensioned shorter than the individual contact pads (16a to 16g) of the supporting plate (10) and the individual contact pads (16a to 16g) of the supporting plate (10) and the common contact pad (17) of the supporting plate (10) are arranged in a row such that the contact with the common contact pad (17) is established in the receiving part (23) later than the contact with the individual contact pads (16a to 16g) of the supporting plate (10) when the supporting plate (10) is inserted into the receiving part (23).

5. Device according to one of claims 1 to 4, **characterized in that** the supporting plate (10) is made of a plastic material, preferably PVC.

6. Device according to one of claims 1 to 5, **characterized in that** the supporting plate (10) is made of a flexible material.

7. Device according to one of claims 1 to 6, **characterized in that** the supporting plate (10) has two rows of openings (13b, 13c, 13d; 13e, 13f, 13g) which are arranged next to each other and run in the longitudinal direction corresponding to the packing system (1) as well as a further opening (13a) centrally arranged at the ends of the rows of the openings being opposite to each other.

8. Device according to claim 7, **characterized in that** on the side of the further opening (13a) facing away from the two rows of openings, the supporting plate (10) has an opening (13) which can be assigned to a compartment (3) of the packing system (1).

9. Device according to one of claims 1 to 8, **characterized in that** on the side of the supporting plate (10) facing away from the coating layer (6), the combination of layers (50) has a cover layer (27) with pull-off areas (2a' to 2g') which cover the openings (13a to 13g) of the supporting plate (10)
and can be pulled out of the cover layer (27) for the removal of a product as required.

10. Device according to claim 9, **characterized in that** the cover layer (27) is made of a papery material.

11. Device according to claim 9 or 10, **characterized in that** the pull-off areas (2a' to 2g') are connected to the side of the supporting plate (10) facing said pull-off areas (2a' to 2g') by means of an adhesive bond which can be detached by applying force and which is removably connected to the cover layer (27) by means of stamped perforations (22).

12. Device according to one of claims 1 to 11, **characterized in that** on a front side, the combination of layers (50) has alignement grooves (15, 15a) or projecting parts arranged transversely to the insertion direction and asymmetrically to the longitudinal center line of the combination of layers (50) engaging with the corresponding projecting parts (29, 29a) or alignment grooves of the receiving part (23) when the combination of layers (50) is inserted into the receiving part (23), wherein the individual contact pads (16a to 16g) of the supporting plate (10) and the common contact pad (17) of the supporting plate (10) are arranged on the front side in such a way that contact is only established in the event that the projecting parts (29, 29a) engage with the alignment grooves (15, 15a).

13. Device according to claims 1 to 12, **characterized in that** on the side edges running parallel to the insertion direction, the combination of layers (50) has slots (14) with which corresponding projections of the receiving part (23) and/or the holding device engage when the combination of layers (50) has reached the correct position in the receiving part (23) and/or in the holding device.

14. Unit comprising a packing system (1) and a device according to one of claims 1 to 13, **characterized in that** the connection between the combination of layers (50) and the packing system (1) is established by means of an adhesive.

15. Unit according to claim 14, **characterized in that** on the sealing film (5), the packing system (1) has fiducial marks (34, 34a) which are visible and detectable through windows (33, 33a) arranged as a combination of layers (50) in the event that the combination of layers (50) has the correct mounting position in relation to the packing system (1).

## Revendications

1. Système pour détecter le retrait de produits d'un dispositif d'emballage (1) au moyen d'une unité électronique, les produits (20) étant agencés dans des poches (2a à 2g) individuelles fermées par une feuille de scellement (5) et la feuille de scellement (5) pouvant être détachée d'une poche (2a à 2g) pour retirer un produit (20), le système comprenant une couche de recouvrement (6) portant des pistes conductrices (7a' à 7g') individuelles et une plaque support (10), la couche de recouvrement (6) pouvant être associée de telle sorte à la feuille de scellement (5) du dispositif d'emballage (1) qu'une piste conductrice (7a' à 7g') individuelle respective de la couche de recouvrement (6) s'étend depuis un spot de contact (7a à 7g) individuel de la couche de recouvrement (6) via une zone de la couche de recouvrement, qui peut être respectivement associée à une poche (2a à 2g) du dispositif d'emballage (1), vers une piste conductrice (9) commune de la couche de recouvrement (6), qui est reliée à un spot de contact (8) commun de la couche de recouvrement (6), la piste conductrice (7a' à 7g') individuelle respective de la couche de recouvrement (6), qui s'étend via la zone de la couche de recouvrement qui peut être associée à la poche, pouvant être interrompue électriquement lors du retrait d'un produit (20) hors de la poche (2a à 2g) correspondante du dispositif d'emballage (1), la plaque support (10) présentant des ouvertures (13a à 13g) dont une peut être respectivement associée à une poche (2a à 2g) du dispositif d'emballage (1), un produit (20) respectif retiré d'une poche (2a à 2g) du dispositif d'emballage (1) pouvant être introduit à travers l'ouverture (13a à 13g) correspondante de la plaque support (10), **caractérisé en ce que** la couche de recouvrement (6) et la plaque support (10) sont réalisées sous forme de stratifié composite (50), la couche de recouvrement étant appliquée sur la plaque support et le stratifié composite pouvant être relié au dispositif d'emballage de telle sorte que la couche de recouvrement est tournée vers la feuille de scellement du dispositif d'emballage, **en ce que** la plaque support (10) présente sur sa face tournée vers la couche de recouvrement (6) des spots de contact (11a a 11g) individuels de la plaque support (10) qui sont associés aux spots de contact (7a à 7g) individuels de la couche de recouvrement (6) et reliés électriquement avec ceux-ci dans le stratifié composite (50), **en ce que** la plaque support (10) présente un spot de contact (12) commun qui est associé au spot de contact (8) commun de la couche de recouvrement (6) et relié électriquement à celui-ci dans le stratifié composite, et **en ce que** chaque spot de contact (11a à 11g) individuel est relié via une piste conductrice (16) individuelle de la plaque support (10) à un spot de contact de connexion (16a à 16g) individuel de la plaque support (10), et le spot de contact (12) commun de la plaque support (10) est relié via une piste conductrice (17a) commune de la plaque support (10) à un spot de contact de connexion (17) commun de la plaque support (10), une liaison électrique vers l'unité électronique pouvant être établie via les spots de contact de connexion (16a à 16g) individuels de la plaque support (10) et via le spot de contact de connexion (17) commun de la plaque support (10) lorsque le stratifié composite (50) relié au dispositif d'emballage (1) est inséré dans une pièce de réception (23) d'un dispositif de retenue, et **en ce que** les spots de contact (7a à 7g) de la couche de recouvrement (6) et le spot de contact (8) commun de la couche de recouvrement (6) ainsi que les spots de contact (11a a 11g) individuels correspondants de la plaque support (10) et le spot de contact (12) commun de la plaque support (10), respectivement, sont reliés électriquement les uns aux autres dans le stratifié composite via un point adhésif conducteur (19).

2. Système selon la revendication 1, **caractérisé en ce que** les pistes conductrices (7a' à 7g') individuelles, la piste conductrice (9) commune, les spots de contact (7a à 7g) individuels et le spot de contact (8) commun de la couche de recouvrement (6) sont agencés sur la face tournée vers la plaque support (10).

3. Système selon la revendication 1 ou 2, **caractérisé en ce que** les spots de contact de connexion (16a à 16g) individuels de la plaque support (10) et le spot de contact (17) commun de la plaque support (10) sont agencés sur une face frontale de la plaque support (10).

4. Système selon la revendication 3, **caractérisé en ce que** vu en direction d'insertion, le spot de contact (17) commun de la plaque support (10) a des dimensions plus courtes que les spots de contact de connexion (16a à 16g) individuels de la plaque support (10) et **en ce que** les spots de contact de connexion (16a à 16g) individuels de la plaque support (10) et le spot de contact (17) commun de la plaque support (10) sont agencés dans une rangée, de telle sorte que la mise en contact dans la pièce de réception (23) vers le spot de contact (17) commun lors de l'insertion de la plaque support (10) dans la pièce de réception (23) est produite plus tard que vers les spots de contact de connexion (16a à 16g) individuels de la plaque support (10).

5. Système selon l'une des revendications 1 à 4, **caractérisé en ce que** la plaque support (10) est en une matière plastique, de préférence en PVC.

6. Système selon l'une des revendications 1 à 5, **caractérisé en ce que** la plaque support (10) est en un matériau flexible.

7. Système selon l'une des revendications 1 à 6, **caractérisé en ce que** la plaque support (10), s'étendant en direction longitudinale de manière correspondante au dispositif d'emballage (1), présente deux rangées agencées l'une à côté de l'autre d'ouvertures (13b, 13c, 13d ; 13e, 13f, 13g) et possède, aux extrémités des rangées opposées des ouvertures, une autre ouverture (13a) agencée au milieu.

8. Système selon la revendication 7, **caractérisé en ce que** la plaque support (10) présente sur la face de l'autre ouverture (13a), qui est détournée des deux rangées d'ouvertures, une ouverture (13) qui peut être associée à un compartiment (3) du dispositif d'emballage (1).

9. Système selon l'une des revendications 1 à 8, **caractérisé en ce que** le stratifié composite (50) présente, sur la face détournée de la couche de recouvrement (6), une couche de couverture (27) avec des zones pelliculable (2a' à 2g') qui recouvre les ouvertures (13a à 13g) de la plaque support (10) et qui peuvent être enlevées de la couche de couverture (27) en cas de besoin pour retirer le produit.

10. Système selon la revendication 9, **caractérisé en ce que** la couche de couverture (27) est en un matériau similaire à du papier.

11. Système selon l'une des revendications 9 ou 10, **caractérisé en ce que** les zones pelliculables (2a' à 2g') sont reliées, par une liaison par collage détachable par application de force, à la face de la plaque support (10) qui est tournée vers elles et sont reliées de manière détachable à la couche de couverture par des lignes estampées (22).

12. Système selon l'une des revendications 1 à 11, **caractérisé en ce que** le stratifié composite (50) présente sur une face frontale des rainures d'orientation (15a, 15a) ou des parties en forme d'ergots agencées transversalement à la direction d'insertion et de façon dissymétrique par rapport à la ligne médiane longitudinale du stratifié composite (50), lesquelles s'engagent dans des parties en forme d'ergots (29, 29a) correspondantes lorsque le stratifié composite (50) est inséré dans la pièce de réception (23), les spots de contact de connexion (16a à 16g) individuels de la plaque support (10) et le spot de contact de connexion (17) commun de la plaque support (10) étant agencés sur la face frontale de telle sorte qu'une mise en contact n'est produite que lorsque les parties en forme d'ergots (29, 29a) s'engagent dans les rainures d'orientation (15, 15a).

13. Système selon l'une des revendications 1 à 12, **caractérisé en ce que** le stratifié composite (50) présente, sur ses bords latéraux s'étendant parallèlement à la direction d'insertion, des fentes (14) dans lesquelles s'engagent des saillies correspondantes de la pièce de réception (23) ou du dispositif de retenue, respectivement, lorsque le stratifié composite (50) a atteint la bonne position dans la pièce de réception (23) ou dans le dispositif de retenue, respectivement.

14. Unité constituée par un dispositif d'emballage (1) et un système selon l'une des revendications 1 à 13, **caractérisée en ce que** la liaison entre le stratifié composite (50) et le dispositif d'emballage (1) est réalisée par un adhésif,

15. Unité selon la revendication 14, **caractérisée en ce que** le dispositif d'emballage (1) présente sur la feuille de scellement (5) des marques de repérage (34, 34a) qui sont visibles et détectable à travers des fenêtres correspondantes agencées dans le stratifié composite (50) lorsque le stratifié composite (50) prend la bonne position de fixation par rapport au dispositif d'emballage (1).
